Europäisches Patentamt

European Patent Office

Office européen des brevets

(11) Veröffentlichungsnummer: **0 321 668**
**A2**

## EUROPÄISCHE PATENTANMELDUNG

(21) Anmeldenummer: 88117202.7

(51) Int. Cl.⁴: **H01H 1/40**

(22) Anmeldetag: 15.10.88

(30) Priorität: 22.12.87 DE 3743460

(43) Veröffentlichungstag der Anmeldung:
28.06.89 Patentblatt 89/26

(84) Benannte Vertragsstaaten:
DE ES FR GB IT SE

(71) Anmelder: **Rafi GmbH & Co Elektrotechnische Spezialfabrik**
**Ravensburger Strasse 128-134**
**D-7981 Berg bei Ravensburg(DE)**

(72) Erfinder: **Pfeiffer, Jakob**
**Mahlerweg 11**
**D-7981 Berg bei Ravensburg(DE)**

(74) Vertreter: **Engelhardt, Guido, Dipl.-Ing.**
**Montafonstrasse 35 Postfach 1350**
**D-7990 Friedrichshafen 1(DE)**

(54) Leiterplatte.

(57) Bei einer Leiterplatte (1) mit einer Leiterbahn (13) die von einem Schleifkontakt (2) abtastbar ist, ist die Leiterbahn (13) durch ein gesondertes Bauteil aus einem abriebfesten elektrisch leitenden Werkstoff gebildet und auf einem plattenförmig gestalteten Träger (11) aus einem Isolierwerkstoff angeordnet.

Durch diese Ausgestaltung ist es nicht nur möglich, die Leiterplatte (1) auf sehr wirtschaftliche Weise herzustellen, sondern deren Leiterbahn (13) weist auch eine hohe Maßgenauigkeit auf, so daß Schaltpunkte exakt festzulegen und eine hohe Standzeit gegeben sind. Des weiteren wird erreicht, daß ein Prellen des Schleifkontaktes (2) nahezu ausgeschlossen ist und daß eine Potentialbildung zwischen diesem und der Leiterplatte (1) vermieden wird.

FIG. 1

## Leiterplatte

Die Erfindung bezieht sich auf eine Leiterplatte mit einer Leiterbahn, die von einem Schleifkontakt abtastbar ist.

Leiterplatten dieser Art werden vielfach in der Weise gefertigt, daß eine kupferkaschierte Isolierstoffplatte entsprechend der gewünschten Leiterbahn mit einem säurefesten Lack bedruckt und die nicht abgedeckten Teile der Kupferschicht mit Säure weggeätzt werden. Dieses Verfahren ermöglicht zwar eine kostengünstige Herstellung, die Kanten der Leiterbahn sind aber oftmals nicht exakt ausgeprägt, so daß Schaltvorgänge, die durch die von einem über die Leiterplatte geführten Schleifkontakt abgegebenen Signale ausgelöst werden, nicht exakt festlegbar sind. Dies führt häufig zu Fehlschaltungen. Auch ist der Verschleiß der aus einer nicht abriebfesten Kupferschicht bestehenden Leiterbahn erheblich und es bildet sich, da der Schleifkontakt, der beim Überfahren einer Kante zum Prellen neigt, aus einem andersartigen Werkstoff besteht, zwischen diesen ein Potential, durch das zusätzlich der Verschleiß gesteigert wird. Die Funktionstüchtigkeit sowie die Standzeit einer in dieser Weise gefertigten Leiterplatte ist daher nicht zufriedenstellend.

Aufgabe der Erfindung ist es daher, eine Leiterplatte der vorgenannten Gattung zu schafffen, die nicht nur auf sehr wirtschaftliche Weise herzustellen ist, sondern deren Leiterbahn auch eine hohe Maßgenauigkeit, so daß Schaltpunkte exakt festzulegen sind, und eine hohe Standzeit aufweist. Des weiteren soll erreicht werden, daß ein Prellen des Schleifkontaktes nahezu ausgeschlossen ist und daß eine Potentialbildung zwischen diesem und der Leiterplatte zuverlässig vermieden wird.

Gemäß der Erfindung wird dies dadurch erreicht, daß die Leiterbahn durch ein gesondertes Bauteil aus einem abriebfesten elektrisch leitenden Werkstoff gebildet und auf einem plattenförmig gestalteten Träger aus einem Isolierwerkstoff angeordnet ist.

Zweckmäßig ist es hierbei, die Leiterbahn durch mechanische Bearbeitung, beispielsweise durch Stanzen, Erodieren, Fräsen oder dgl. einer Platine, herzustellen und in eine in den Träger eingearbeitete Vertiefung einzusetzen, wobei die Oberfläche der in einer Vertiefung eingesetzten Leiterbahn in einer Ebene mit der Oberfläche des Trägers verlaufen sollte.

Die Leiterbahn kann aber auch auf den Träger aufgesetzt und die freien Flächen des Trägers können mit einer Maske aus einem Isolierwerkstoff, die in ihrer Stärke vorzugsweise der Materialstärke der Leiterbahn entspricht, versehen werden. Wird die Maske aus einem metallischen Werkstoff hergestellt, ist zwischen dieser und der Leiterbahn eine Isolierung einzusetzen.

Die Leiterbahn kann durch Kleben, Klemmen, Verprägen oder dgl. fest mit dem Träger verbunden und zweckmäßigerweise aus einem Kupfer-Beryllium-Band oder einem Federstahlband hergestellt werden.

Ferner kann die Leiterbahn mit einem Anschlußkontakt für eine Signalleitung versehen, auch können auf dem Träger mehrere Leiterbahnen nebeneinander und/oder auf beiden Seiten angeordnet werden.

Der Träger kann aus Kunststoff oder aus Keramik-Aluminium-Oxyd hergestellt werden.

Und bestehen die Leiterbahn und der diese abtastende Schleifkontakt aus dem gleichen Werkstoff, ist es nahezu ausgeschlossen, daß sich zwischen diesen ein Potential bildet.

Wird eine Leiterplatte gemäß der Erfindung ausgebildet, in dem die Leiterbahn durch ein gesondertes mechanisch zu bearbeitendes Bauteil besteht, das auf einem Träger angeordnet wird, so ist diese nicht nur in sehr einfacher Weise und wirtschaftlich zu fertigen, sondern es ist auch, da die Materialien entsprechend gewählt werden können, eine hohe Abriebfestigkeit und damit eine hohe Standzeit gegeben. Vor allem aber wird durch die große Maßgenauigkeit der mechanisch bearbeiteten Leiterbahn erreicht, daß die Schaltpunkte exakt festlegbar und somit keine Fehlschaltungen in Kauf zu nehmen sind. Und da der Schleifkontakt nicht über erhöhte Kanten geführt wird, diese können vielmehr durch Einlegen der Leiterbahn in eine Vertiefung oder mit Hilfe einer Maske ausgeglichen werden, ist ein Prellen des Schleifkontaktes nahezu ausgeschlossen.

Des weiteren ist von Vorteil, daß der Schleifkontakt aus dem gleichen Werkstoff wie die Leiterbahn hergestellt werden kann. Dadurch wird eine Potentialbildung und damit eine elektrochemische Reaktion zwischen diesen vermieden und die Lebensdauer beider Bauteile gesteigert. Bei Verwendung einer erfindungsgemäßen Leiterplatte ist demnach eine stets sichere Funktion eines Schleifkontaktes gewährleistet.

In der Zeichnung ist ein Ausführungsbeispiel einer gemäß der Erfindung ausgebildeten Leiterplatte dargestellt, das nachfolgend im einzelnen erläutert ist. Hierbei zeigt:

Figur 1 die Leiterplatte in Vorderansicht,

Figur 2 die Leiterplatte nach Figur 1 in Rückansicht,

Figur 3 die Leiterplatte nach Figur 1 in einer Seitenansicht,

Figur 4 die bei der Leiterplatte nach Figur 1 vorgesehene Leiterbahn,

Figur 5 die Leiterbahn nach Figur 4 in einer Seitenansicht und

Figur 6 eine andersartige Anordnung einer Leiterbahn auf einem Träger in einer Schnittdarstellung.

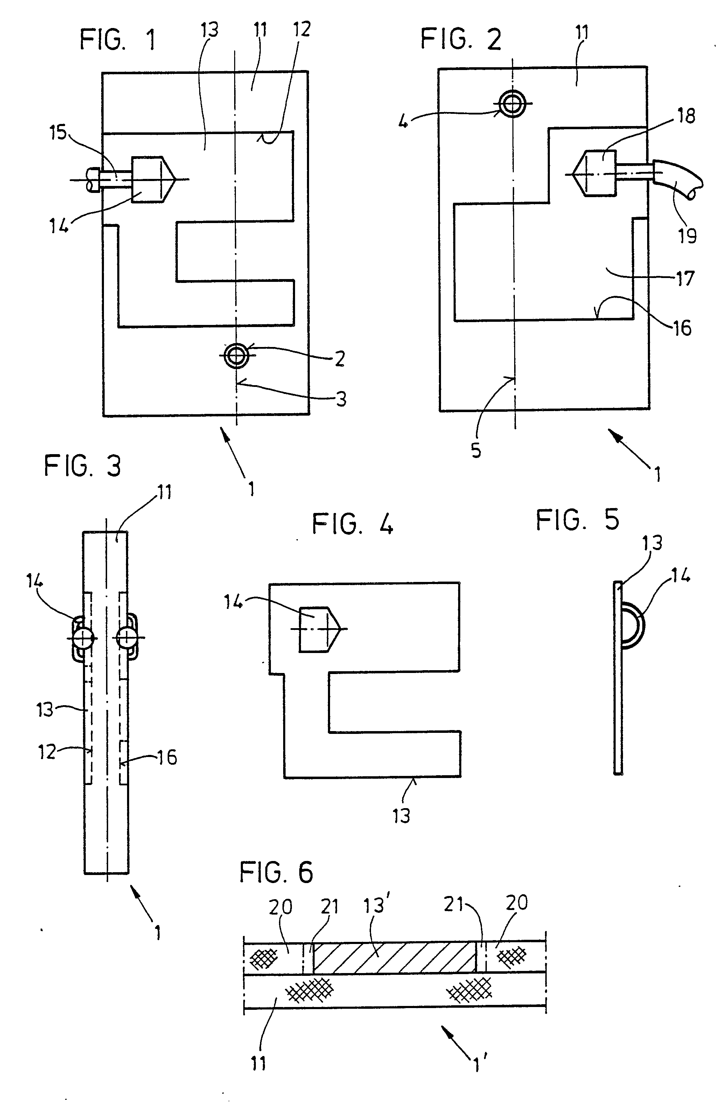

Die in den Figuren 1 bis 3 dargestellte und mit 1 bezeichnete Leiterbahn ist Schleifkontakten 2 und 4 zugeordnet, die beidseitig der Leiterplatte 1 in Schaltspuren 3 bzw. 5 über diese hinweggeführt werden und dabei Schaltsignale erzeugen. Um dies zu bewerkstelligen, ist die Leiterplatte 1 mit Leiterbahnen 13 und 17 aus einem elektrisch leitenden Werkstoff versehen, die auf einem Träger 11 aus einem Isolierwerkstoff aufgebracht sind.

Die Leiterbahnen 13 und 17 sind hierbei, wie dies den Figuren 4 und 5 zu entnehmen ist, als gesondertes Bauteil ausgebildet und durch mechanische Bearbeitung einer Platine hergestellt, beispielsweise aus einem abriebfesten Kupfer-Beryllium oder Federstahlband, ausgestanzt. Die Maß- und Schaltgenauigkeit ist damit außerordentlich hoch. Um überhöhte Kanten zu vermeiden, sind die Leiterbahnen 13 und 17 in in den Träger 11 eingearbeitete Vertiefungen 12 bzw. 16 eingesetzt und durch Kleben oder Verprägen fest mit diesem verbunden. Da die Oberflächen des Trägers 11 und der Leiterbahnen 13, 17 auf gleicher Höhe liegen, erfolgt somit der Übergang der Schleifkontakte 2 und 4 stufenlos, so daß ein Prellen nahezu ausgeschlossen ist. Des weiteren können, um eine Potentialbildung zu verhindern, die Leiterbahnen 13 und 17, die mit ausgestanzten Laschen 14 bzw. 18 zum Befestigen von Signalleitungen 15 und 19 versehen sind, aus dem gleichen Werkstoff wie die an diesen anliegenden Teilen der Schleifkontakte 2 und 4 hergestellt werden.

Bei der in Figur 6 dargestellten Leiterplatte 1′ ist eine Leiterbahn 13′ unmittelbar auf dem Träger 11 befestigt und dessen freie Oberfläche ist durch eine Maske 20 aus einem Isolierwerkstoff, die die gleiche Materialstärke aufweist wie die Leiterbahn 13′, abgedeckt. Wird eine Maske aus einem elektrisch leitenden Werkstoff verwendet, ist zwischen dieser und der Leiterbahn 13′, wie dies strichpunktiert eingezeichnet ist, verständlicherweise eine Isolierung 21 vorzusehen.

**Ansprüche**

1. Leiterplatte mit einer Leiterbahn, die von einem Schleifkontakt abtastbar ist,
**dadurch gekennzeichnet,**
daß die Leiterbahn (13, 17) durch ein gesondertes Bauteil aus einem abriebfesten elektrisch leitenden Werkstoff gebildet und auf einem plattenförmig gestalteten Träger (11) aus einem Isolierwerkstoff angeordnet ist.

2. Leiterplatte nach Anspruch 1,
**dadurch gekennzeichnet,**
daß die Leiterbahn (13, 17) durch mechanische Bearbeitung, beispielsweise durch Stanzen, Erodieren, Fräsen oder dgl. aus einer Platine hergestellt ist.

3. Leiterplatte nach Anspruch 1 oder 2,
**dadurch gekennzeichnet,**
daß die Leiterbahn (13, 17) in eine in den Träger (11) eingearbeitete Vertiefung (12, 16) eingesetzt ist.

4. Leiterplatte nach Anspruch 3,
**dadurch gekennzeichnet,**
daß die Oberfläche der in einer Vertiefung (12, 16) eingesetzten Leiterbahn (13, 17) in einer Ebene mit der Oberfläche des Trägers (11) verläuft.

5. Leiterplatte nach Anspruch 1 oder 2,
**dadurch gekennzeichnet,**
daß die Leiterbahn (13′) auf den Träger (11) aufgesetzt und daß die freien Flächen des Trägers (11) mit einer Maske (20) aus einem Isolierwerkstoff, die in ihrer Stärke vorzugsweise der Materialstärke der Leiterbahn (13′) entspricht, versehen ist.

6. Leiterplatte nach Anspruch 5,
**dadurch gekennzeichnet,**
daß die Maske (20) aus einem metallischen Werkstoff hergestellt und daß zwischen dieser und der Leiterbahn (13′) eine Isolierung (21) eingesetzt ist.

7. Leiterplatte nach einem oder mehreren der Ansprüche 1 bis 6,
**dadurch gekennzeichnet,**
daß die Leiterbahn (13, 17) durch Kleben, Klemmen, Verprägen oder dgl. fest mit dem Träger (11) verbunden ist.

8. Leiterplatte nach einem oder mehreren der Ansprüche 1 bis 7,
**dadurch gekennzeichnet,**
daß die Leiterbahn (13, 17) aus einem Kupfer-Beryllium-Band oder einem Federstahlband hergestellt ist.

9. Leiterplatte nach einem oder mehreren der Ansprüche 1 bis 8,
**dadurch gekennzeichnet,**
daß die Leiterbahn (13, 17) mit einem Anschlußkontakt (14, 18) für eine Signalleitung (15, 19) versehen ist.

10. Leiterplatte nach einem oder mehreren der Ansprüche 1 bis 9,
**dadurch gekennzeichnet,**
daß auf dem Träger (11) mehrere Leiterbahnen (14, 17) nebeneinander und/oder auf beiden Seiten angeordnet sind.

11. Leiterplatte nach einem oder mehreren der Ansprüche 1 bis 10,
daß der Träger (11) aus Kunststoff oder aus Keramik-Aluminium-Oxyd hergestellt ist.

12. Leiterplatte nach einem oder mehreren der Ansprüche 1 bis 11,
**dadurch gekennzeichnet,**
daß die Leiterbahn (13, 17) und der diese abtastende Schleifkontakt (2) aus dem gleichen Werkstoff besteht.

FIG. 1

15

14

13 11 12

2

2

3

1

FIG. 2

11

4

18

19

17

16

5

1

FIG. 3

11

14

13

12

16

1

FIG. 4

14

13

FIG. 5

13

14

FIG. 6

20 21 13' 21 20

11

1'